(19) **Europäisches Patentamt**

**European Patent Office**

**Office européen des brevets**

(11) Veröffentlichungsnummer : **0 316 298 B1**

(12) # EUROPÄISCHE PATENTSCHRIFT

(45) Veröffentlichungstag der Patentschrift :
**06.05.92 Patentblatt 92/19**

(51) Int. Cl.⁵ : **C30B 33/00, C30B 29/14**

(21) Anmeldenummer : **88890275.6**

(22) Anmeldetag : **03.11.88**

(54) **Verfahren zur Verringerung des Wassergehaltes in piezoelektrischen Galliumphosphat-Kristallelementen.**

Teilanmeldung 91100350.7 eingereicht am 03/11/88.

(30) Priorität : **11.11.87 AT 2983/87**
**23.12.87 AT 3424/87**

(43) Veröffentlichungstag der Anmeldung :
**17.05.89 Patentblatt 89/20**

(45) Bekanntmachung des Hinweises auf die Patenterteilung :
**06.05.92 Patentblatt 92/19**

(84) Benannte Vertragsstaaten :
**BE CH DE FR GB IT LI NL SE**

(56) Entgegenhaltungen :
**EP-A- 0 123 809**
**FR-A- 2 524 497**
**JOURNAL OF CRYSTAL GROWTH, Band 80, Nr. 1, Januar 1987, Seiten 133-148, Elsevier Science Publishers B.V., Amsterdam, NL; J.C.JUMAS et al.: "Crystal growth of berlinite, AlPO4: physical characterization and comparison with quartz"**

(56) Entgegenhaltungen :
**JOURNAL OF CRYSTAL GROWTH, Band 79, Teil 1, Nr. 1-3, 2. Dezember 1986, Seiten 215-218, Elsevier Science Publishers B.V., Amsterdam, NL; S.I. HIRANO et al.: "Hydrothermal synthesis of gallium orthophosphate crystals" Organikum. VEB Verlag der Wissenschaften, Berlin, 1969; Seiten 66, 67.**

(73) Patentinhaber : **AVL Gesellschaft für Verbrennungskraftmaschinen und Messtechnik mbH.Prof.Dr.Dr.h.c. Hans List Kleiststrasse 48 A-8020 Graz (AT)**

(72) Erfinder : **Engel, Günter, Dipl.-Ing. Dr. Dorfstrasse 58 A-8430 Leitring (AT)**
Erfinder : **Krempl, Peter W., Dr. Kainbach 211 A-8047 Graz/Ragnitz (AT)**
Erfinder : **List, Helmut, Dipl.-Ing. Bogengasse 36 A-8010 Graz (AT)**
Erfinder : **Posch, Uwe, Dipl.-Ing. Custozzagasse 1 A-8020 Graz (AT)**
Erfinder : **Nitsch, Alfred Am Dürrgraben 16 A-8045 Graz (AT)**

(74) Vertreter : **Krause, Walter, Dr. Dipl.-Ing. et al Postfach 200 A-1014 Wien (AT)**

## Beschreibung

Die Erfindung betrifft ein Verfahren zur Verringerung des Wassergehaltes in piezoelektrischen $GaPO_4$-Kristallelementen.

Die Kristallelemente beispielsweise für Meßwertaufnehmer werden meist unter Vermeidung des Keimlings aus dem $GaPO_4$- Rohkristallbarren geschnitten, geformt, geschliffen, gereinigt sowie mit Elektroden versehen und in das jeweilige Gehäuse eingebaut.

Viele Eigenschaften beispielsweise eines Meßwertaufnehmers wurden bisher fast ausschließlich den Eigenschaften und der Bauart des Aufnehmergehäuses oder der mit der zu messenden Größe in Kontakt stehenden Membran zugeschrieben. Tatsächlich weisen jedoch Meßwertaufnehmer gleicher Bauart, ausgestattet mit den gleichen Kristallelementen, Unterschiede im Isolationsverhalten, in der Temperaturschockbelastbarkeit, der maximalen Druckbelastung und der Linearität auf, sowie kleine aber meßbare Abweichungen in wichtigen Eigenschaften wie Elastizität und piezoelektrische Empfindlichkeit.

Auch bei Resonatoren werden nachteilige Eigenschaften vor allem durch unterschiedliche Frequenzkonstanten bei gleichen Schnittwinkeln, durch unterschiedliche Temperaturkoeffizienten von Resonanzfrequenzen sowie durch irreversible Alterungsphänomene der Kristallelemente hervorgerufen.

Ein maßgebliches Qualitätskriterium für praktisch alle Anwendungen piezoelektrischer Kristallelemente ist der Spurengehalt von $H_2O$, wobei diesen Gehalt so niedrig wie möglich gehalten werden soll. Für Quarz und $AlPO_4$ sind daher Verfahren bekannt, den $H_2O$-Gehalt bereits von der Züchtung her zu kontrollieren. Gleiches gilt auch für die Züchtung von $GaPO_4$, wo z.B. mit hoher Säurekonzentration gearbeitet wird, um den $H_2O$-Gehalt von vornherein niedrig zu halten.

Eine weitere Möglichkeit den $H_2O$-Gehalt zu minimieren, bietet sich dadurch an, daß die Löslichkeit von $H_2O$ in $GaPO_4$-Kristallen retrograd ist, d.h., mit steigender Temperatur sinkt. Die sich daraus ergebende Strategie der Züchtung bei hohen Temperaturen wird jedoch durch die Korrosivität der Zuchtlösung begrenzt. Bei dem aus der AT-PS 379 831 bekannten Verfahren sind bei hohen Säurekonzentrationen unter günstigen Voraussetzungen $H_2O$-Spurenwerte von ca. 50 ppm zu erzielen. Es ist auch hier der Einfluß der Wachstumsrate auf den $H_2O$-Gehalt zu berücksichtigen, sodaß bei schneller wachsenden Kristallen Wassergehalte bis zu 150 ppm gemessen werden.

Da höhere Wachstumsraten bei niedrigem Spurengehalt an $H_2O$ anzustreben sind, müssen Methoden zur nachträglichen Reduktion des $H_2O$-Gehaltes angewandt werden.

Bisher sind dazu vor allen Verfahren wie Ausheizen, sowie Ausheizen im Vakuum angewandt worden, welche den Nichtgleichgewichtszustand des $H_2O$ bei Temperaturen des Kristalls ausnützen, welche weit über seiner Züchtungstemperatur liegen. Das so erzeugte Ungleichgewicht des $H_2O$ im Kristallgitter kann aber zu Schädigungen in der Struktur führen. Es bilden sich beispielsweise sogenannte Wasserblasen, welche die Qualitätsverbesserung durch Verminderung des $H_2O$-Gehaltes wieder zunichte machen.

In diesem Zusammenhang wurde auch bereits vorgeschlagen, die Kristallelemente mittels Elektrodiffusion zu behandeln. Durch den Elektrodiffusionsprozeß, d.h. anlegen hoher Spannung und dadurch induzierte Ionendiffusion, werden zwar die obengenannten Nachteile vermieden, der Prozeß ist aber ungleich aufwendiger, da die Elektrodenbereiche senkrecht zur z-Achse der Kristallelemente nach dem Diffusionsprozeß gekappt werden müssen, um die dort angereicherten Fremddionen zu entfernen.

Aufgabe der vorliegenden Erfindung ist es, ein Verfahren vorzuschlagen, mit welchem der Spurengehalt ans Wasser in piezoelektrischen Kristallelementen entscheidend vermindert werden kann. Zusätzlich sollen die Werte für alle wichtigen phyzikalischen Parameter, wie Elastizität und piezoelektrische Empfindlickeit, nur geringste Streuungen aufweisen.

Diese Aufgabe wird erfindungsgemäß dadurch gelöst, daß die piezoelektrischen $GaPO_4$-Kristalellemente mit einer wasserentziehenden Lösung in Kontakt gebracht werden, bis bei einer Wellenlänge im Bereich von 2,9 µm für die $GaPO_4$-Kristallelemente ein Infrarot-Koeffizient $\alpha < 1,5\ cm^{-1}$, mit

$\alpha = l/d \log (lo/l)$

lo...Intensität der Primärstrahlung

l....Intensität der Transmissionsstrahlung

d....Dicke des Kristallelementes

erreicht wird, insbesondere soll der Infrarot-Koeffizient $\alpha < 0,8\ cm^{-1}$ sein. So kann beispielsweise bei einer Verfahrensdauer von 24 Stunden eine Abnahme des Wassergehaltes von durchschnittlich 5 bis 20 % erwartet werden. Die vom Wassergehalt abhängigen physikalischen Parameter der $GaPO_4$-Kristallelemente, beispielsweise der Resonanzgütefaktor, wird verbessert, während andere vom Wassergehalt unabhängige Eigenschaften aufgrund des schonenden Verfahrens unverändert bleiben.

Da die Schwingungsgüte piezoelektrischer Elemente direkt mit dem $H_2O$-Spurengehalt korreliert, bringt das erfindungsgemäße Verfahren Vorteile für alle Resonatorapplikationen, aber auch für Oberflächenwellenanwendungen, da insbesondere in der aktiven Schicht der für diese Zwecke verwendeten Kristallplättchen geringste $H_2O$-Werte erreichbar sind.

Durch das neue Verfahren ist es auch möglich, Zuchtverfahren für $GaPO_4$-Kristallelemente vorzuschlagen, bei welchen niedrige Zuchttemperaturen angewandt werden, da der bis jetzt zwingende Grund für höhere Temperaturen, der des geringeren Wassereinbaus, durch das der Züchtung nachfolgende Extraktionsverfahren relativiert wird.

Zur Bestimmung des Wassergehaltes einer kristallinen Probe aus dem Infrarot-Spektrum genügt bei bekannter Intensität Io der Primärstrahlung und bekannter Dicke d des Kristallelementes an sich die Bestimmung der Transmission I an einer Stelle, beispielsweise bei ca. 2,9 µm (entspricht einer Wellenzahl von ca. 3.400 $cm^{-1}$). Für genaue Messungen kann auch zusätzlich bei einer Referenzwellenzahl gemessen werden, bei welcher nur Absorptionen des Kristallgitters wirksam sind, bzw. bei einer Wellenzahl von 3.400 $cm^{-1}$ eines wasserfreien Kristalls. Wasserfreie Kristalle im Sinne eines Verschwindens des Wasserpeaks bei 3.400 $cm^{-1}$ können relativ einfach aus deuterierten Zuchtlösungen gezüchtet werden, wobei ein Deuterierungsgrad von 99,7 % ausreicht, um dem Restgehalt an Wasser unberücksichtigt zu lassen. Durch die Deuterierung wird der Schwerwasserpeak, welcher durch die O-D-Schwingungen verursacht wird, in den Bereich unter ca. 2.600 $cm^{-1}$ verschoben, sodaß bei 3.400 $cm^{-1}$ nur Absorptionen des Kristallgitters auftreten.

In einer speziellen Ausführung der Erfindung ist vorsegehen, daß die $GaPO_4$-Kristallemente in eine Mischung aus Karl-Fischer-Lösung und absolutem Methanol in einem Volumsverhältnis von 4 : 1 bis 1 : 4 eingelegt werden. Die zu behandelnden piezoelektrischen Kristallelemente werden in eine Mischung aus KF-Lösung und absolutem Methanol eingelegt, wobei das Methanol sowohl als Lösungsmittel dient, als auch als Reagens, welche in die Reaktion durch Bildung eines Übergangskomplexes eingreift. Die Konzentration der KF-lösung ist vorteilhafterweise so zu wählen, daß 1 ml Lösung einem Wassergehalt von 2 bis 5 mg entspricht.

Von Vorteil ist in diesem Zusammenhang die Verwendung von pyridinfreier KF-Lösung, da Geruchsbelästigungen während des Verfahrens wegfallen.

Die mit Hilfe des Infrarot-Spektrometers gewonnenen Werte des $H_2O$-Gehaltes können durch eine Titration nach Karl Fischer überprüft werden, wofür einige der vorher der Infrarot-Messung unterzogenen Kristallelemente gewogen und unter Ausschluß von Luftfeuchtigkeit verrieben werden müssen. Die gepulverten Proben werden ebenfalls unter Ausschluß von Luftfeuchtigkeit in die Titrierzelle eingebracht. Als Titriermittel findet beispielsweise KF-Reagens pyridinfrei MERCK 9258® Verwendung.

Bei hinreichend geringen Wasserspuren kann auch die Methode der coulometrischen Titration vorteilhaft sein.

Eine Weiterbildung des erfindungsgemäßen Verfahrens sieht vor, daß die $GaPO_4$-Kristallelemente in eine Mischung aus KarlFischer-Lösung und absolutem Methanol im Volumsverhältnis 1 : 1 eingelegt werden und die Mischung unter Ausschluß von Luffeuchtigkeit in einem geschlossenen System erhitzt wird. Im geschlossenen System, z. B. in einem Stahlautoklav, baut sich durch das Erhitzen ein Druck auf, der ein Desorbieren des in der KF-Lösung gelösten $SO_2$ verhindert. Dadurch werden bessere Extraktionswerte in kürzerer Zeit erzielt. Ein Sieden der KF-Lösung würde zum Desorbieren des in der KF-Lösung gelösten $SO_2$ führen und das Extraktionsvermögen der Lösung rasch erschöpfen.

Um höhere Verfahrenstemperaturen - welche im Idealfall nahe bei der Züchtungstemperatur des Kristalls liegen - zu erreichen, kann erfindungsgemäß die Mischung aus Karl-FischerLösung und absolutem Methanol bei einem Druck bis 20 bar auf eine Temperatur bis 300°C erhitzt werden.

Eine andere Ausführungsvariante der Erfindung sieht vor, daß die $GaPO_4$-Kristallelemente in einem Reaktionskolben in ein mit Wasser nicht mischbares, organisches Lösungsmittel mit einer im Spurenbereich hohen Affinität zu Wasser eingelegt werden. Dieses Verfahren verwendet ein organisches Lösungsmittel, welches zwar nur eine begrenzte Menge Wasser aufnimnt, im Spurenbereich jedoch eine hohe Affinität zu Wassen zeigt.

In einer Weiterbildung des Verfahrens wird das organische Lösungsmittel im Reaktionskolben bis zum Siedepunkt erhitzt, das entstehende Dampfgemisch aus Lösungsmitteldampf und Wasserdampf am Rückfluß abgekühlt, sowie in einem dem Reaktionskolben vorgeschalteten Extraktor das Wasser, vorzugsweise mittels eines Molekularsiebes, aus dem Lösungsmittel entfernt. Die Kristalle werden dabei in das siedende Lösungsmittel eingelegt, wo dann ein Gemisch aus Lösungsmittel, und Wasser verdampft. Dieser Dampf wird am Rückfluß abgekühlt und fließt nun nicht direkt in den Reaktionskolben zurück, sondern zuerst in einen Extraktor, der entweder Extraktionsmittel oder ein Molekularsieb für Wasser enthält. Dort wird das Wasser, welches sich im organischen Lösungsmittel gelöst hat, entfernt, das reine Lösungsmittel fließt zurück in den Reaktionskolben und der Prozeß beginnt von vorne. Diese Prozeßführung hat den Vorteil, daß sie kontinuierlich betrieben werden kann. Erfindungsgemäß kann dabei ein organisches Lösungsmittel aus der Gruppe Toluol, Benzol oder Xylol zur verwendung kommen.

Schießlich ist erfindungsgemäß vorgesehen, daß die wasserentziehende Lösung über einen Zeitraum von einem halben Tag bis 60 Tagen mit den $GaPO_4$-Kristallelementen in Kontakt bleibt. Bei 20 Tagen Prozeßdauer ist beispeilsweise eine Reduktion des $H_2O$-Gehaltes um 90 % denkbar, was auch für anspruchsvollste Resonatoranwendungen ausreichend ist. Zu erwähnen ist in diesem Zusammenhang, daß Resonatorplättchen üblicherweise dünner sind als Kristallelemente für andere Anwendungen, sodaß das Verfahren hier noch wirksamer zur Geltung kommt. Auch bei Oberflächenwellenelementen ist die aktive Schicht, welche die akustiche Dämpfung bestimmt, sehr dünn, sodaß auch hier die entsprechenden Spezifikationen gut erfüllbar sind. Auch bei Kristallelementen mit bereits vom Züchtungsprozeß sehr niedrigen Wassergehalten ist durch das erfindungsgemäße Verfahren eine weitere Absenkung des $H_2O$-Gehaltes möglich.

Da sowohl das Lösungsmittel des KF-Reagens (Etylenglycolmonomethylether) als auch Z.B. Toluol einen sehr niedrigen Flammpunkt (12°C bzw. 6°C) und niedrige Zünd- bzw. Explosions- temperaturen aufweisen, sind gewisse Sicherheitsvorkehrungen zu beachten. Außerdem ist das Einatmen der Dämpfe und Berührung der Reaktionsflüssigkeit mit der Haut zu vermeiden.

Zur Verringerung des Wassergehaltes in piezoelektrischen $GaPO_4$-Kristallelementen kann beispeilsweise ein Soxhlet-Extraktor (Siehe Organikum; VEB Deutscher Verlag der Wissenschaften; Berlin 1969; Seiten 66/67) verwendet werden. Der beheizbare Reaktionskolben zur Aufnahme der $GaPO_4$-Kristallelemente enthält z.B. ein organisches Lösungsmittel und steht mit einem Rückflußkühler in Verbindung. Der Ausgang des Rückflußkühlers mündet in den Extraktor, welcher ein Molekularsieb enthält. Weiters ist der Extraktor ausgangsseitig mit dem Reaktionskolben verbindbar. Selbstverständlich können im Extraktor auch andere geeignete Trockenmittel, z.B. $CaCl_2$ oder $Na_2SO_4$, zur Anwendung kommen. Im von einem Silikonölbad beheizten Reaktionskolben kann auch der Rührstab eines Magnetrührers angeordnet sein.

Im folgenden wird die vorliegende Erfindung anhand von Zeichnungen näher erläutert.Es zeigen:

Fig. 1 eine Vorrichtung zur Durchführung des erfindungsgemäßen Verfahrens und die

Fig. 2 bis 5 Infrarot-Spektren von $GaPO_4$-Kristallelementen.

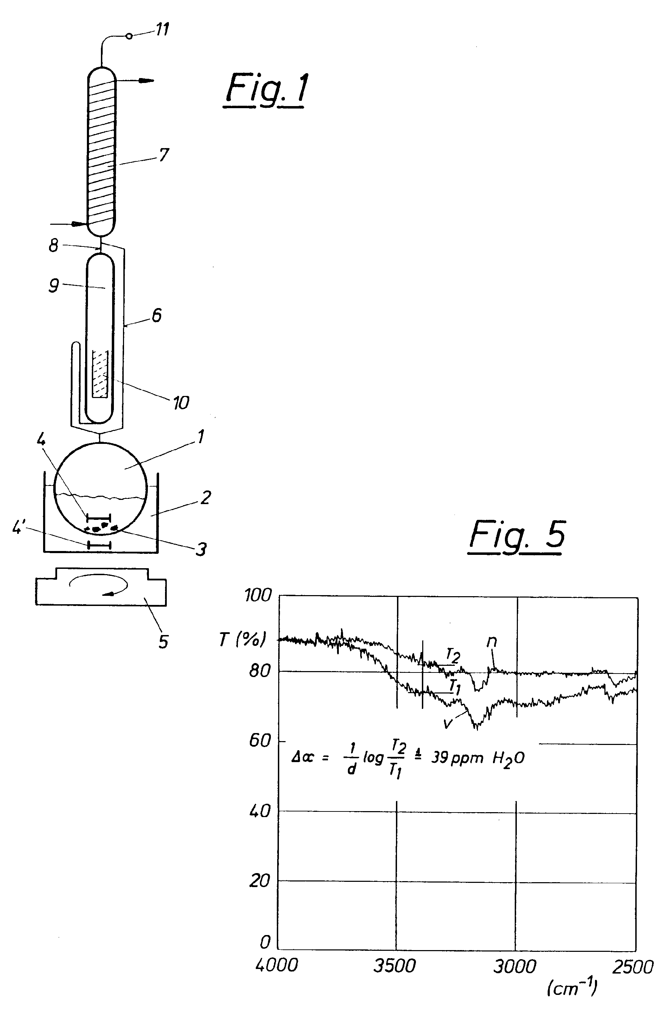

Die in Fig. 1 dargestellte Vorrichtung weist einen Reaktionskolben 1 auf, der über ein mit Silikonöl gefülltes Wärmebad 2 geheizt wird. Im als Rundkolben ausgeführten Reaktionskolben 1 befinden sich $GaPO_4$-Kristallelemente 3 im Lösungsmittel Toluol. Sowohl im Reaktionskolben 1 als auch im Wärmebad 2 befinden sich Rührstäbe 4, 4', die von einem Magnetrührer 5 in Bewegung versetzt werden. Die vom siedenden Lösungsmittel aufsteigenden Lösungsmitteldämpfe gelangen mit dem aus den Kristallelementen 3 stammenden Wasserdampf durch die Leitung 6 in den Rückflußkühler 7 und treten nach deren Kondensation über dem Ausgang 8 des Rückflußkühlers in den Soxhlet-Extraktor 9 ein. Hier wird im Molekularsieb 10 das Wasser aus dem Lösungsmittel entfernt, wonach das reine Lösungsmittel in den Reaktionskolben zurückfließt. Über das Anschlußventil 11 ist der Rückflußkühler 7 und der damit verbundene Extraktor 9, sowie der Reaktionskolben 1 mit einer hier nicht weiter dargestellten Trockenvorlage verbunden, welche das Eindringen von Luftfeuchtigkeit in die Vorrichtung verhindert.

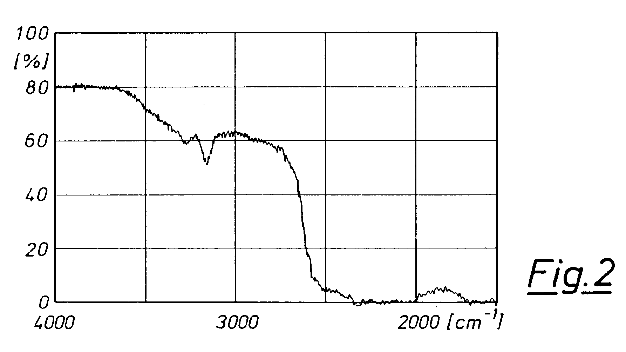

In den Fig. 2 bis 5 ist jeweils auf der Ordinate die Transmission in % und auf der Abszisse die Wellenzahl in $cm^{-1}$ aufgetragen. Der Wassergehalt der Probe ist aus dem Infrarot-Transmissionswert im Bereich von 3400 $cm^{-1}$ (2,9μm) ersichtlich.

Das Spektrum in Fig. 2 zeigt, daß die Infrarotabsorption von in deuterierter Phosphorsäure hergestellten $GaPO_4$-Kristallbarren ($\alpha = 0,66$ $cm^{-1}$) auch bei Wellenlängen über ca. 2,8 μm überraschend hoch ist, was möglicherweise auf Gitterabsorptionen in diesem Wellenlängenbereich hinweist, da in dem in deuterierter Phosphorsäure hergestellten Kristall Wasser in Form von $H_2O$ praktisch nicht anzutreffen ist und als Verursacher ausfällt, sowie die Schwerwasserabsorption erst bei Wellenzahlen unter 2600 $cm^{-1}$ einzetzt (wie auch in Fig. 2 sehr gut erkennbar ist). Es konnte empirisch gefunden werden, daß für $GaPO_4$ $\alpha < 1,5$ $cm^{-1}$ eine notwendige Bedingung dafür ist, daß alle auf das Schneiden folgenden weiteren Bearbeitungsschritte der Kristallelemente bei Einhalten üblicher Verarbeitungsregeln schadlos überstanden werden, genügend hohe Isolationswerte in Meßwertaufnehmern erzielt werden und ein fehlerfreies Funktionieren gegeben ist.

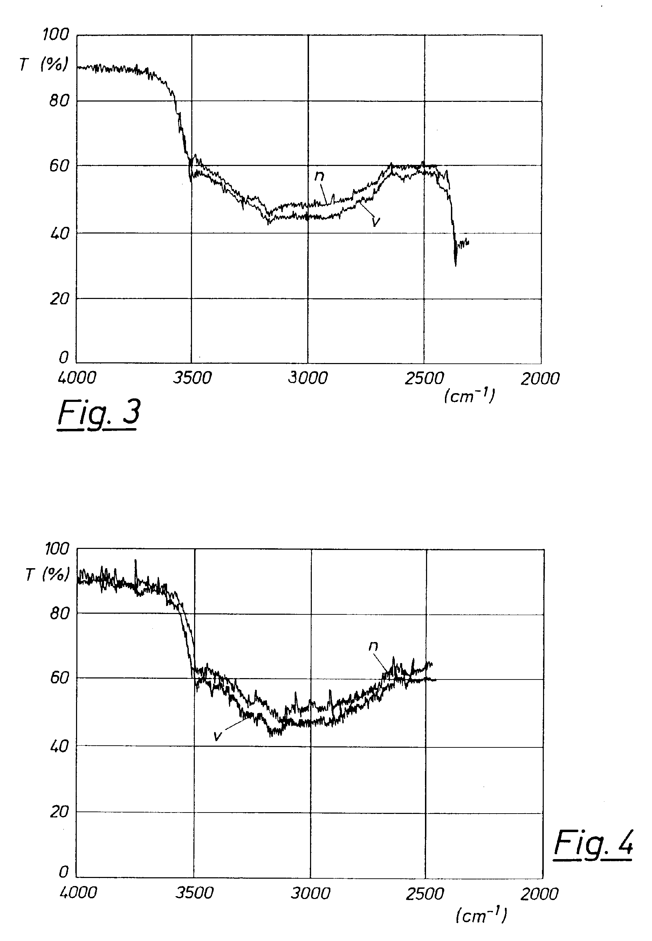

Einige Resultate des erfindungsgemäßen Extraktionsverfahrens sind nun anhand von Infrarot-Spektren von $GaPO_4$-Kristallelementen in den Fig. 3 bis 4 ersichtlich, wo die Verringerung des $H_2O$-Gehaltes aus der verringerten IR-Absorption im Hydroxylbandenbereich entnehmbar ist. Die Messkurve vor Durchführung der $H_2O$-Extraktion ist jeweils mit v bezeichnet und die das Ergebnis darstellende Meßkurve mit n.

In allen Fällen erfolgt eine deutliche Reduktion des Wassergehaltes in den Proben, wobei in Fig. 3 die Extraktion von $H_2O$ in methanolischer KF-Lösung über einen Zeitraum von 24 Stunden erfolgte. Eine weitere Möglichkeit ist die Extraktion mit Toluol. Das Ergebnis einer 48 Stunden Extraktion ist in Fig. 4 dargestellt. Zusammenfassend für $GaPO_4$ kann gesagt werden, daß der Wassergehalt bei einer Extraktionszeit von 24 Stunden durchschnittlich um ca. 10 % sinkt, wie die systematische Abnahme der Absorption im Hydroxylbereicht feststellen läßt. Der Vergleich von Spektren, die sich durch mehrere Extraktionsschritte unterscheiden, zeigt, daß der Prozeß auch über einen längeren Zeitraum wirksam ist.

Fig. 5 zeigt den Vergleich zweier Spektren einer Probe mit sehr geringem Wassergehalt, an welcher über einen Zeitraum von 14 Tagen mehrere Extraktionsversuche durchgeführt wurden.

Die Spektren dieser Probe weisen eine Absorption auf, welche bereits des Null-Linie der Infrarot-Absorption sehr nahe kommt. Aus diesen Grund wird die Bestimmung des absoluten Wassergehaltes sehr ungenau, die Differenz des Wassergehaltes vor und nach der Extraktionsbehandlung kann jedoch nach wie vor genau bestimmt werden. Der Wassergehalt der Probe nach Fig. 5 beträgt größenordnungsmäßig 10 ppm.

Die Bestimmung der Null-Linie erfolgt z.B. durch die Vermessung von Kristallelementen, welche aus deuterierten Zuchtlösungen (siehe Fig. 2) gezüchtet werden, da hier die $H_2O$-Ab-sortion bei 3400 $cm^{-1}$ entfällt.

Das hier beschriebene Wasserextraktionsverfahren stellt somit eine aussichtsreiche Möglichkeit zur Verminderung des $H_2O$-Spurengehaltes in $GaPO_4$-Kristallelementen dar.

## Patentansprüche

1. Verfahren zur Verringerung des Wassergehaltes in piezoelektrischen $GaPO_4$-Kristallelementen, **dadurch gekennzeichnet,** daß die piezoelektrischen $GaPO_4$-Kristallelemente mit einer wasserentziehenden Lösung in Kontakt gebracht werden, bis bei einer Wellenlänge im Bereich von 2,9 µm für die $GaPO_4$-Kristallelemente ein Infrarot-Koeffizient $\alpha < 1,5$ $cm^{-1}$, mit

$\alpha$ = l/d log (lo/l)

lo...Intensität der Primärstrahlung

l....Intensität der Transmissionsstrahlung

d....Dicke des Kristallelementes

erreicht wird.

2. Verfahren nach Anspruch 1, **dadurch gekennzeichnet,** daß der Infrarot-Koeffizient $\alpha < 0,8$ $cm^{-1}$ ist.

3. Verfahren nach Anspruch 1, **dadurch gekennzeichnet,** daß der $GaPO_4$-Kristallelemente in eine Mischung aus Karl-Fischer-Lösung und absolutem Methanol in einem Volumsverhältnis von 4 : 1 bis 1 : 4 eingelegt werden.

4. Verfahren nach Anspruch 3, **dadurch gekennzeichnet,** daß die $GaPO_4$-Kristallelemente in eine Mischung aus Karl-Fischer-Lösung und absolutem Methanol im Volumsverhältnis 1 : 1 eingelegt werden und die Mischung unter Ausschluß von Luftfeuchtigkeit in einem geschlossenen System erhitzt wird.

5. Verfahren nach Anspruch 3, **dadurch gekennzeichnet,** daß die Mischung aus Karl-Fischer-Lösung und absolutem Methanol bei einem Druck bis 20 bar auf eine Temperatur bis 300°C erhitzt wird.

6. Verfahren nacht Anspruch 1, **dadurch gekennzeichnet,** daß die $GaPO_4$-Kristallelemente in einem Reaktionskolben in ein mit Wasser nicht mischbares, organisches Lösungsmittel mit einer im Spurenbereich hohen Affinität zu Wasser eingelegt werden.

7. Verfahren nach Anspruch 6, **dadurch gekennzeichnet,** daß das organische Lösungsmittel im Reaktionskolben bis zum Siedepunkt erhitzt wird, daß das entstehende Dampfgemisch aus Lösungsmitteldampf und Wasserdampf am Rückfluß abgekühlt wird, sowie daß in einem dem Reaktionskolben vorgeschalteten Extraktor das Wasser aus dem Lösungsmittel entfernt wird.

8. Verfahren nach Anspruch 6, **dadurch gekennzeichnet,** daß als organisches Lösungsmittel ein Lösungsmittel aus der Gruppe Toluol, Benzol und Xylol verwendet wird.

9. Verfahren nach Anspruch 1, **dadurch gekennzeichnet,** daß die wasserentziehende Lösung über einen Zeitraum von einem halben Tag bis 60 Tagen mit den $GaPO_4$-Kristallelementen in Kontakt bleibt.

## Claims

1. Method of reducing the water content of piezoelectric $GaPO_4$ crystal elements, <u>characterised in that</u> the piezoelectric $GaPO_4$ crystal elements are brought into contact with a water-extracting solution until there is achieved for the $GaPO_4$ crystal element at a wavelength in the region of 2.9µm an infra-red coefficient $\alpha$ less than 1.5cm $^{-1}$, where

$\alpha$ = l/d log (lo/l)

lo ... Intensity of the primary radiation

l .... Intensity of the transmitted radiation

d .... Thickness of the crystal element.

2. Method according to claim 1 characterised in that the infra-red coefficient $\alpha$ is less than 0.8cm $^{-1}$.

3. Method according to claim 1 characterised in that the $GaPO_4$ crystal element is introduced into a mixture of Karl-Fischer solution and absolute methanol at a volume ratio of 4:1 to 1:4.

4. Method according to claim 3 characterised in that the $GaPO_4$ crystal elements are introduced into a mixture of Karl-Fischer solution and absolute methanol at a volume ratio of 1:1 and the mixture is heated in a closed system with the exclusion of atmospheric moisture.

5. Method according to claim 3 characterised in that the mixture of Karl-Fischer solution and absolute methanol is heated at a pressure up to 20 bar to a temperature up to 300°C.

6. Method according to claim 1 characterised in that the $GaPO_4$ crystal elements are placed in a reaction vessel in an organic solvent which is inmiscible with water with a high affinity for water in the trace range.

7. Method according to claim 6 characterised in that the organic solvent is heated in the reaction vessel to boiling point, that the resulting vapour mixture of solvent vapour and water vapour is cooled on the reflux and that the water is extracted from the solvent in an extractor connected ahead of the reaction vessel.

8. Method according to claim 6 characterised in that a solvent taken from the group comprising toluene, benzene and xylene is employed as the organic solvent.

9. Method according to claim 1 characterised in that the water-extracting solution remains in contact with the $GaPO_4$ crystal elements over a time period of from half a day up to 60 days.

## Revendications

1. Procédé pour réduire la teneur en eau dans des éléments cristallins piézo-électriques en phosphate de gallium, procédé caractérisé en ce que les éléments cristallins piézo-électriques en phosphate de gallium sont mis en contact avec une solution déshydratante, jusqu'à ce que soit obtenu, pour les éléments cristallins en phosphate de gallium, pour une longueur d'ondes voisine de 2,9 $\mu$m, un coefficient infra-rouge $\alpha < 1,5$ cm$^{-1}$, avec :

$\alpha = l/d \log (lo/l)$

lo ..... étant l'intensité du rayonnement primaire

I ...... étant l'intensité du rayonnement de transmission

d ...... étant l'épaisseur de l'élément cristallin.

2. Procédé selon la revendication 1, caractérisé en ce que le coefficient infra-rouge est $\alpha < 0,8$ cm$^{-1}$.

3. Procédé selon la revendication 1, caractérisé en ce que les éléments cristallins en phosphate de gallium sont placés dans un mélange de solution Karl-Fischer et de méthanol absolu en un rapport de volume de 4 : 1 à 1 : 4.

4. Procédé selon la revendication 3, caractérisé en ce que les éléments cristallins en phosphate de gallium sont placés dans un mélange de solution Karl-Fischer et de méthanol absolu dans un rapport de volume 1 : 1 et en ce que le mélange est chauffé à l'abri de l'humidité de l'air dans un système fermé.

5. Procédé selon la revendication 3, caractérisé en ce que le mélange d'une solution Karl-Fischer et de méthanol absolu est chauffé à une température allant jusqu'à 300°C pour une pression allant jusqu'à 20 bars.

6. Procédé selon la revendication 1, caractérisé en ce que les éléments cristallins en phosphate de gallium sont placés dans un ballon à réaction dans un solvant organique non miscible à l'eau et ayant dans le domaine des traces, une haute affinité pour l'eau.

7. Procédé selon la revendication 6, caractérisé en ce que le solvant organique dans le ballon à réaction est chauffé jusqu'au point d'ébullition, en ce que le mélange de vapeur de solvant et de vapeur d'eau prenant naissance est refroidi au reflux, et en ce que l'eau est enlevée du solvant dans un extracteur branché en amont du ballon à réaction.

8. Procédé selon la revendication 6, caractérisé en ce que, comme solvant organique, on utilise un solvant du groupe toluène, benzène et xylène.

9. Procédé selon la revendication 1, caractérisé en ce que la solution déshydratante reste en contact avec les éléments cristallins en phosphate de gallium sur un espace de temps allant d'une demi-journée jusqu'à 60 jours.

_Fig.1_

_Fig. 5_

$$\Delta\alpha = \frac{1}{d}\log\frac{T_2}{T_1} \stackrel{\triangle}{=} 39\,ppm\ H_2O$$

*Fig.2*

_Fig. 3_

_Fig. 4_